Europäisches Patentamt

European Patent Office

Office européen des brevets

(11) Publication number: **0 146 232**
**B1**

## EUROPEAN PATENT SPECIFICATION

(45) Date of publication of patent specification: 08.06.88

(21) Application number: 84307160.6

(22) Date of filing: 18.10.84

(51) Int. Cl.⁴: **H 01 B 1/14,** H 01 C 7/00, H 01 L 27/01, H 01 L 21/70

(54) Resistor materials.

(30) Priority: 20.10.83 JP 196415/83

(43) Date of publication of application: 26.06.85 Bulletin 85/26

(45) Publication of the grant of the patent: 08.06.88 Bulletin 88/23

(84) Designated Contracting States: DE FR GB IT

(56) References cited:
DE-A-2 949 740
GB-A-1 393 869

ELECTRONICS vol. 53, no. 1, 3rd January 1980, New York, USA; R. ALLAN "Thin-film devices on silicon chip withstand up to 500C" pages 39-40

(73) Proprietor: FUJITSU LIMITED
1015, Kamikodanaka Nakahara-ku
Kawasaki-shi Kanagawa 211 (JP)

(72) Inventor: Toyokura, Nobuo c/o FUJITSU LIMITED
Patent Department 1015 Kamikodanaka Nakahara-ku
Kawasaki-shi Kanagawa 211 (JP)
Inventor: Ohnishi, Toyokazu c/o FUJITSU LIMITED
Patent Department 1015 Kamikodanaka Nakahara-ku
Kawasaki-shi Kanagawa 211 (JP)
Inventor: Yokoyama, Naoki c/o FUJITSU LIMITED
Patent Department 1015 Kamikodanaka Nakahara-ku
Kawasaki-shi Kanagawa 211 (JP)

(74) Representative: Sunderland, James Harry et al
HASELTINE LAKE & CO Hazlitt House 28
Southampton Buildings Chancery Lane
London WC2A 1AT (GB)

Courier Press, Leamington Spa, England.

## Description

The present invention to thin film resistors for application in semiconductor integrated circuit (IC) devices.

As microelectronics rapidly penetrates various fields of industry, semiconductor devices such as silicon semiconductor ICs are playing an increasingly important role in those fields. Although silicon ICs are dominant at present, ICs of compound semiconductors, such as gallium-arsenide (GaAs) semiconductor, which offer higher carrier mobility are becoming more widespread because of their higher switching speeds and lower power consumptions. For both kinds of semiconductor product mentioned above, higher packaging density is also required to improve their performance and to minimize the size of electronic devices in which ICs are used.

For a microelectronic device, particularly for an IC, resistors are important elements. Polycrystalline silicon (polysilicon) resistors are widely used for silicon ICs, whilst bulk resistors are used for compound semiconductor ICs. Usually such resistors are formed in a substrate of an IC together with other elements such as capacitors and transistors. However, there are several limitations on the charactertistics of such resistors and on the conditions under which such resistors can be fabricated which limitations represent problems to be solved.

For example, polysilicon resistors are employed for high resistive loads for static memory cell circuits and inverter logic circuits. These resistors are of high resistance, for example 10 MΩ to 10 GΩ, and of fine dimensions such as 2 μm wide, 3 μm long and 0.3 μm thick. Accordingly the resistivity required of the resistors (the material of which they are formed) is approximately $10^5$ to $10^6 \Omega$cm ($10^3$ to $10^4$ $\Omega$m). Such a high resistivity is attained from polysilicon by controlling dopant concentration in the polysilicon. However, resistivity of polysilicon is very sensitive to variation of doptant concentration. If phosphorus dopant concentration varies from $1 \times 10^{18}$atm/cm$^3$ to $4 \times 10^{18}$ atm/cm$^3$ ($1 \times 10^{24}$ to $4 \times 10^{24}$ atm/m$^3$) (i.e. changes by a factor of four), for instance, the resistivity of polysilicon changes (increases sharply) $10^5$ times. This sharp change (extreme sensitivity) of resistivity with respect to dopant concentration represents a serious problem: it is very difficult to achieve control sufficient to provide a specified value of resistance. Generally it is considered that the resistivity of polysilicon resistor material is determined by the bulk resistivity of crystalline grains, actual resistivity of grain boundaries and space charge potential barriers. In relation to these matters, reference may be made to a report, for example, on page 682, Vol. ED. 29, No. 4, APL 1982, IEEE Transactions on Electron Devices, by Nicky Chau Chun Lu and others. As a result, the resistivity also depends on the grain size and grain boundary density of the polysilicon. However, control of grain size during the crystal growth is difficult, and further grain growth in subsequent heating processes above 900°C is unavoidable, resulting in a change of resistivity.

Polysilicon is easily influenced by adjacent layers of a semiconductor device. For instance, it is reported that in the case of a polysilicon layer covered with a silicon nitride ($Si_3N_4$) layer formed by a plasma deposition method, the resistivity of the polysilicon layer decreased by a factor of 1000 as a result of heating at 450°C for 2 hours. It is considered that this would be ascribed to the occurrence of fixed charges and surface stage of the interface between the polysilicon layer and the insulator (silicon nitride) layer.

Furthermore, if a surrounding region adjacent to a polysilicon resistor region is heavily doped, the dopants contained in the surrounding region tend to diffuse into the polysilicon resistor region. As a result, a marginal area of the polysilicon resistor region along its boundary with the surrounding region is doped and looses its resistivity, leading to a reduction of the resistivity of the polysilicon resistor region. To take into account such reduction in resistivity a resistor should be designed to have initially a higher resistivity than that ultimately required. This has an adverse effect on the packing density which can be achieved.

In addition, precise patterning is difficult when forming resistors in a semiconductor substrate by a selective diffusing method. Ion implantation patterning can assure higher accuracy of the dimensions of resistors, but this method is not applicable to a compound semiconductor IC such as a gallium-arsenide GaAS) IC, because the temperature which can be used in a subsequent heat treatment for duffusion of implanted dopants is limited due to the high evaporation rate of elementary materials such as arsenic (As) and is not sufficient to activate implanted dopants, resulting in uncontrolled resistor resistivity.

Particularly with compound semiconductor ICs, resistors for the ICs are formed in the IC substrates thus occupying substrate area, decreasing packing density.

In efforts to overcome one or more of the drawbacks of polysilicon resistors as described above, heat resistant resistor materials have been developed. A typical such material is "cermet" which is a mixture of oxide materials such as aluminium oxide ($Al_2O_3$), beryllium oxide (BeO) and zirconium oxide ($ZrO_2$) and metals such as iron (Fe), nickel (Ni), cobalt (Co), chrome (Cr), copper (Cu), etc. "cermet" is a heat resistive resistor material and stands heating at 1000°C. However, metals contained in "cermet" tend to react with oxygen to convert to metal oxide. This makes it difficult to control the rsistance of "cermet" resistors. Furthermore, in a compound semiconductor, "cermet" is not substantially applicable because of the temperature limitation in its heat treatment ad described above.

A heat resistant material which has been used for film resistors or for discrete resistors is tantalum nitride (TaN) which is distinguished by its moisture proof properties and its stability during its lifetime. Recently, a resistor based on tantalum nitride has been proposed in Japanese patent application, TOKU-KAI-SH058—14501 (published on Jan. 27 1983) by K. TANAKA, wherein a tantalum-silicon-nitrogen alloy layer, containing 20 to 80 atomic percent silicon (Si), is formed in an atmosphere including nitrogen ($N_2$) gas with partial pressure of $0.5 \times 10^{-5}$ to $8 \times 10^{-5}$ Torr. ($6.67 \times 10^{-4}$ to $10.67 \times 10^{-3}$ Pa). The material can be heated to temperatures below 800°C. A resistor of this material is substantially a tantalum silicide resistor having a relatively low range of resistivity from $4 \times 10^{-1}$ to $2 \times 10^{-2}\Omega$cm ($4 \times 10^{-3}$ to $2 \times 10^{-4}\Omega$m). Accordingly, this is not suitable for silicon transistors.

GB—A—1 393 869 discloses processes for production of conductive ceramic artefacts involving a mixture of silicon nitride and a conductive component (carbon or molybdenum) reacted with silicon.

According to the present invention, there is provided a thin film resistor, comprising a thin film of resistor material, which resistor material is substantially a mixture of silicon nitride and grains of tungsten and/or tungsten silicide or molybdenum and/or molybdenum silicide dispersed in the silicon nitride, formed on an insulative substrate.

According to the present invention, there is also provided a method of forming a thin film resistor comprised of a thin film of resistor material, which resistor material is substantially a mixture of silicon nitride and grains of tungsten and/or tungsten silicide or molybdenum and/or molybdenum silicide dispsersed in the silicon nitride, on an insulative substrate, the method comprising:

forming the thin film of resistor material on the insulative substrate by a reactive sputtering process, in a nitrogen-containing atmosphere, with a partial pressure of nitrogen of at least $1 \times 10^{-4}$ Torr ($1.334 \times 10^{-2}$ Pascal), in which silicon and tungsten or molybdenum are co-sputtered by ion bombardment of target means containing silicon and tungsten or molybdenum.

An embodiment of the present invention can provide thin film resistors for use in semiconductor devices, offering a wide range of resistivities, and hence of resistance values, suitable for silicon ICs and compound semiconductor ICs, having significant thermal stability and excellent reproducibility. Low temperature dependency and ease of fabrication can also be afforded.

An embodiment of the present invention can provide thin film resistors for use in silicon semiconductor devices, which are immune from dopant diffusion from adjacent regions and sufficiently heat resistive during processes involved in fabrication of the devices.

An embodiment of the present invention can provide thin film resistors, for compound semiconductor devices, which are suitably matched to the fabrication processes of such devices and which can be formed to overlay other elements of the devices, thereby avoiding taking up surface area of the substrates of the devices.

Briefly, a resistor in accordance with an embodiment of the present invention is formed of a layer formed in (on) a semiconductor substrate or other substrate comprising a mixture of metal and/or its silicide and silicon nitride ($Si_3N_4$). In this case, the metal silicide is not essential. The metal silicide is formed unintentionally in the fabrication of the resistor. The metal may be molybdenum (Mo) or tungsten (W).

Resistor materials employed in thin film resistors according to embodiments of the present invention have been studied with the aid of physical measuring methods such as XPS (X ray photospectroscopy), RBS (Rutherford back scattering) and X ray diffraction. As a result, it has been found that the structure of such materials is a mixed structure of silicon nitride ($Si_3N_4$) and metal (molybdenum or tungsten) and/or its silicide, and it is estimated that grains of metal and/or silicide of the metal are arranged uniformly separated from each other and surrounded by silicon nitride ($Si_3N_4$).

Since the resistivity of a metal such as tungsten (W) is approximately only one tenth that of a silicide of the metal such as tungsten silicide ($WSi_2$), the total resistivities of the materials depend mainly on the silicon nitride ($Si_3N_4$) component contained in the materials. The resistivity of silicon nitride is significantly higher than that of the metal or silicide of the metal by several orders. Grain boundary density has also some influence on the total resistivity of the material, because electric barriers on the boundary suppress the movement of carriers. Therefore the resistivity is controlled by controlling the composition of silicon nitride ($Si_3N_4$) and the grain size of metal and/or metal silicide.

A resistive material layer for providing a resistor in accordance with the present invention is formed most effectively by a reactive sputtering method carried out in an atmosphere including nitrogen ($N_2$) gas of suitable partial pressure. The atmosphere may for example be a mixed gas of nitrogen and a rare gas. The relationship between the formation of silicon nitride ($Si_3N_4$) and the partial pressure of nitrogen ($N_2$) has been examined carefully by the XPS method. It was found that with a nitrogen gas partial pressure below around $10^{-4}$ Torr (to $1.33 \times 10^{-2}$ Pa), silicon nitride was not detected in the structure of the resistive material formed. On the other hand, partial pressures in the range approximately $1 \times 10^{-4}$ to $5 \times 10^{-2}$ Torr ($1.33 \times 10^{-2}$ to 6.67 Pa) were found most suitable for a stable reactive sputtering process. As a result, nitrogen gas pressures as mentioned above are mostly adopted in connection with embodiments of the present invention which will be described later.

Selection of the ratio of metal to silicon nitride ($Si_3N_4$) is effected by selecting suitable targets and ion acceleration energy in the reactive sputtering process. One method of selection involves selection of the area-ratio of targets of the metal, tungsten (W) for example, and of silicon. The controlling of the ion acceleration energy also provides the equivalent effect for the selection of the material ratio of the resistor to be formed. In mass production, a target of mixed material of metal and silicon, such as a mixture of powdered material of metal and silicon, with a specified mixing ratio is effective.

By selecting suitable ratios of sputtering of metal and silicon, resistive materials comprising a mixture of metal and silicon nitride and offering a very wide range of the resistivities, from $10^{-3}$ to $10^{-9}$ $\Omega$cm ($10^{-5}$ to $10^{-7}$ $\Omega$m), can be obtained in accordance with the present invention.

In consideration of the application of thin film resistors in accordance with embodiments of this invention to ICs, the diffusion behavior of dopants, phosphorus dopants for example, contained inside such resistors was studied. The mobility of dopants in the resistor materials was found to be extremely small, suggesting that such resistors used in ICs are immune from the instrusion at high temperature of dopants contained in adjacent doped regions. Accordingly, the resistivities of the resistors can be maintained stable throughout their fabricating processes and duration time.

In addition, thin film resistors provided by embodiments of this invention are highly heat resistive and thermally stable. The activation energy of the resistivity of such resistors has been found to be lower than that of a conventional polysilicon resistor by 1/2.5 times.

Reference is made, by way of example, to the accompanying drawings, in which:—

Fig. 1 is a cross-sectional view of an IC substrate having an FET and to be provided with a resistor in accordance with an embodiment of the present invention, illustrating the structure of the substrate before the formation of the resistor,

Fig. 2 is a cross-sectional view of the IC substrate of Fig. 1, illustrating the structure of the substrate after the resistor has been formed on the substrate,

Fig. 3 is a cross-sectional view of the IC substrate of Fig. 1 in a finished condition,

Fig. 4 is a graph illustrating relationships beween resistivity and the ratio X of tungsten (W) in resistor materials, in accordance with an embodiment of the present invention, designated as $W_x(Si_3N_4)_{1-x}$, subject to various heat treatment conditions,

Fig. 5 is a graph illustrating relationship between resistivity and atomic ratio Si/W=3(1-x)/x for resistor materials, in accordance with an embodiment of the present invention, designated as $W_x(Si_3N_4)_{1-x}$,

Fig. 6 is a graph illustrating relationships between resistivity and the ratio of molybdenum (Mo) in resistor materials, in accordance with an embodiment of the present invention, designated as $Mo_x(Si_3N_4)_{1-x}$ subject to various heat treatment conditions,

Fig. 7 is a graph illustrating relationship between resistivity and atomic ratio Si/Mo-3(1-x)/x for resistor materials, in accordance with an embodiment of the present invention, designated as $Mo_x(Si_3N_4)_{1-x}$,

Fig. 8 (a) to (d) are rspective graphs illustrating measurement results obtained by an X-ray photospectroscopy (XPS) method, indicative of the compositions of resistive materials in accordance with embodiments of the present invention,

Fig. 9 is a graph illustrating phosphorus dopant distribution in a vertical (depth) direction of a probe containing a film of resistive material in accordance with an embodiment of the present invention,

Fig. 10 is a graph illustrating relationships between activation energy and resistivity at room temperature of resistors according to embodiments of the present invention, respectively containing tungsten and molybdenum as components, as compared with the relationship for a polysilicon material,

Fig. 11 is a cross-sectional view illustrating the structure of a Ga-As compound semiconductor IC having an FET and a resistor, which resistor is provided in accordance with the present invention, and

Fig. 12 is an equivalent circuit diagram of the circuit shown for the Ga-AS IC of Fig. 11.

As indicated above, thin film resistors according to embodiments of the present invention use resistor materials which are mixtures of silicon nitride ($Si_3N_4$) and molybdenum (Mo) or tungsten (W) and/or their silicides. By controlling the mixing ratio of these elements, a wide range of resistivities from $10^{-3}$ to $10^{-9}$ $\Omega$ cm ($10^{-5}$ to $10^{-7}$ $\Omega$ m) can be obtained with such materials.

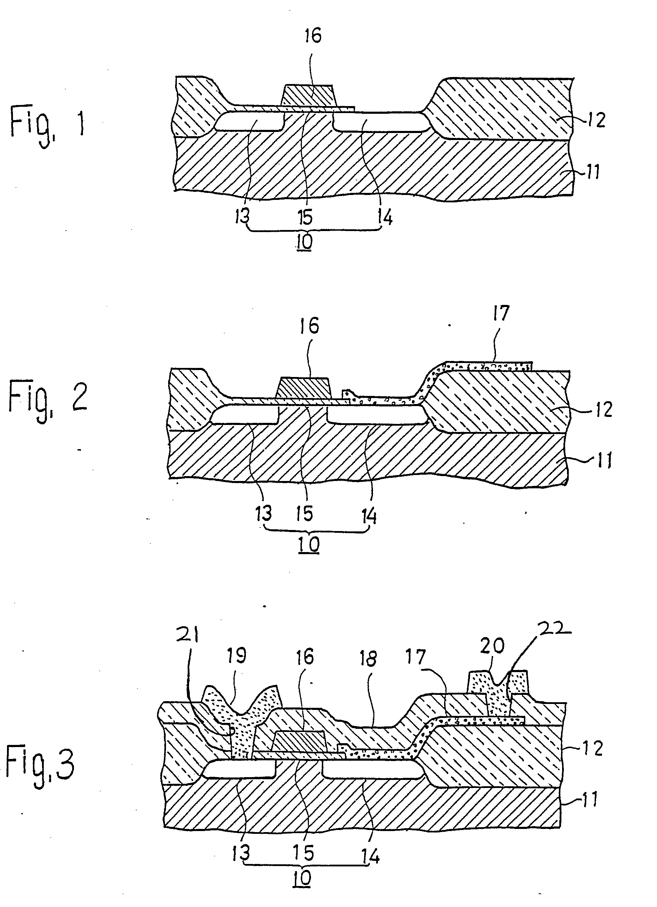

Fig. 1 to Fig. 3 are respective cross-sectional views illustrating steps in the fabrication of an IC including a resistor in accordance with an embodiment of the present invention. As seen in the cross-sectional view of Fig. 1, a MOS FET 10 (metal-oxide-semiconductor field effect transistor) is formed in a transistor region of the IC defined by field oxide layers 12 in a silicon substrate 11. The FET comprises a source region 13, a drain region 14, a gate insulating film 15 and a gate electrode 16. A resistor in accordance with an embodiment of the present invention is formed in the IC.

For fabricating the resistor, in one case tungsten and silicon were used as the materials of a sputtering target. Tungsten powders and silicon powders were mixed with a predetermined mixing ratio and hot pressed to form a target for reactive sputtering. The target was sputtered by bombardment with nitrogen and argon ions. Partial pressure of nitrogen ($N_2$) gas was selected to a value in the range $1 \times 10^{-4}$ to $5 \times 10^{-2}$ Torr ($1.334 \times 10^{-2}$ to 6.67 Pa). Sputtered tungsten (W) and silicon (Si) react with nitrogen and form a resistive film layer 0.3 $\mu$m thick covering all exposed (uppermost) surfaces in Fig. 1. In this case, if the substrate 11 is heated to approximately 500°C, in advance, the resistivity of the resistive layer will be stable during subsequent heat treatments. The layer is patterned to form a resistor 17, using conventional photo-lithographic technology, as shown in Fig. 2. After this, an insulator layer 18 is formed and a metal (aluminium) wiring 19 for ground (Vss) and another wiring 20 for power source (Vdd) are formed on the insulator layer 18. The wirings 19 and 20 are connected to the source region 13 and the resistor 17 respectively through respective contact holes 21 and 22 opened in the insulator layer 18.

Unlike a polysilicon resistor, the resistor 17 does not form a parasitic MOS device, providing a stable and reproducible resistor.

The structure of the material of such a resistor 17 was analyzed physically with the aid of various physical analysis methods such as an X-ray diffraction method, X-ray photo-spectroscopy and a Rutherford back scattering method. As a result, the structure of the resistive layer material was found to be a mixture, wherein grains of tungsten or tungsten plus tungsten silicide are distributed in silicon nitride ($Si_3N_4$) formed during the reactive sputtering by reaction between nitrogen and silicon. This structure is denoted as $W_x(Si_3N_4)_{1-x}$. However, this does not mean that $W_x(Si_3N_4)_{1-x}$ is a chemical compound as a whole.

Generally, heat resistance is an important factor for such a resistor 17 formed in a semiconductor device (IC), because the resistor may be subjected to several heat treatment processes, such as diffusion processes, in fabrication steps for forming the IC which take place subsequent to formation of the resistor.

Resistors in accordance with embodiments of this invention have been found to have excellent heat stability.

After a heat treatment of the material of such a resistor at 1000°C, there was found to be little change in composition binding energy.

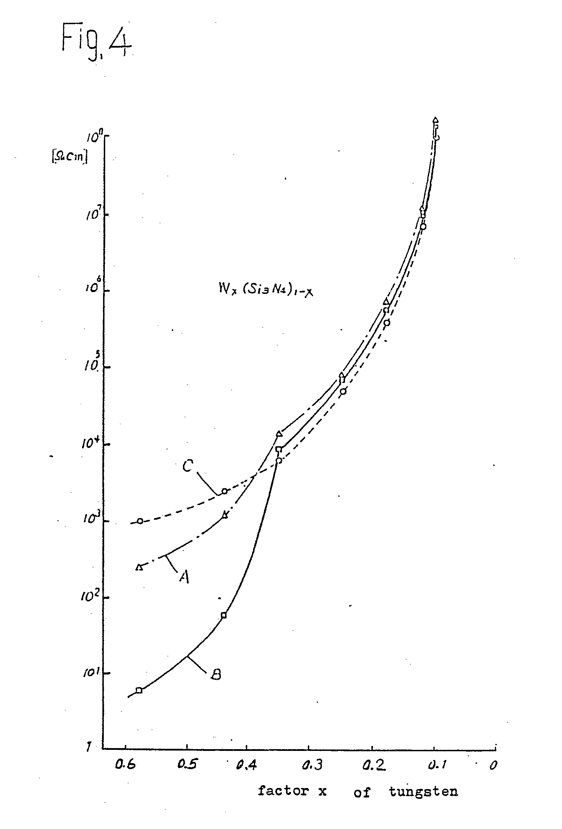

Results of relevant experiments are illustrated in the graph of Fig. 4. In the Figure, the resistivities ($\Omega$ cm) of resistor materials denoted as $W_x(Si_3N_4)_{1-x}$ are plotted against composition factor x. Curve A (chain line) shows values of resistivity immediately after formation of the resistor materials, curve B (solid line) shows values of resistivity after the resistor materials has been subjected to heat treatment of 800°C for 20 minutes, and curve C (broken line) shows values of resistivity after the resistor materials had been subjected to heat treatment at 1000°C. As is clearly seen from the Fig. 4, the three curves A, B and C substantially coincide with one another for mixing factors x below 0.35. This means that the resistor materials are sufficiently heat resistant.

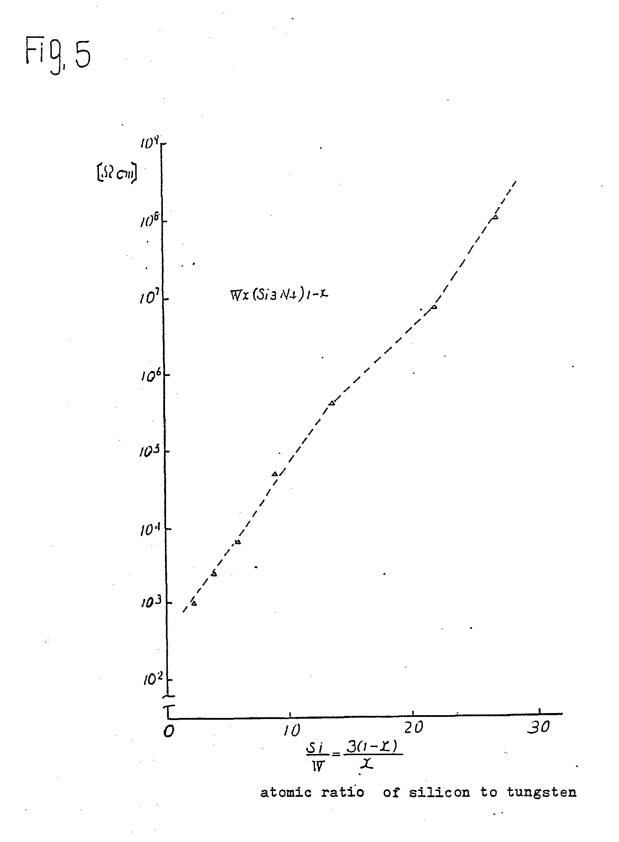

The observed results (values of resistivity) of curve C in Fig. 4 are re-plotted against atomic ratio of Si to W in the resistor materials in Fig. 5. The obtained values of resistivity almost conform to a straight line. This implies that it is easy to control the resistivity of resistors, and that resistivity can be varied over a wide range, 10 to $10^8$ $\Omega$ cm. ($10^{-1}$ to $10^6$ $\Omega$ m). This means that resistors in accordance with the present invention have a wide field of application.

In particular for values of x less than approximately 0.35, heat treatments of the resistor materials at 800°C and 1000°C provide almost similar resistivities. This indicates high thermal stability of the resistor materials, providing for ease and reproducibility in fabrication. The provision of this thermal stability is considered to be due to the structure of the resistive materials layers.

It is believed that the structure of the resistor material can be understood as (Modelled as) a structure in which grains of tungsten or tungsten plus tungsten silicide are surrounded by silicon nitride ($Si_3N_4$), which silicon nitride prevents movement and grain growth of the grains at high temperature. The silicon nitride ($Si_3N_4$) also prevents the intrusion of impurities into the resistor material and reduces the influence of reducing atmospheres such as hydrogen ($H_3$) employed in heat treatment furnaces.

The resistivity of tungsten silicide is higher than that of tungsten (W) by one order, whilst the resistivity of silicon nitride ($Si_3N_4$ is very much greater than that of tungsten or tungsten silicide; greater by ten or nine orders of magnitude ($10^{10}$ to $10^9$). Accordingly, the total resistivity of the resistor materials depends mainly on the resistivity of the silicon nitride and the total resistivity can be controlled by controlling distance between tungsten grains.

Apparently, metal silicide is not an essentially present component of resistor materials (thin film resistors) employing this invention. Metal silicide occurs unintentionally during a reactive sputtering process used for forming the resistive materials layer (resistor).

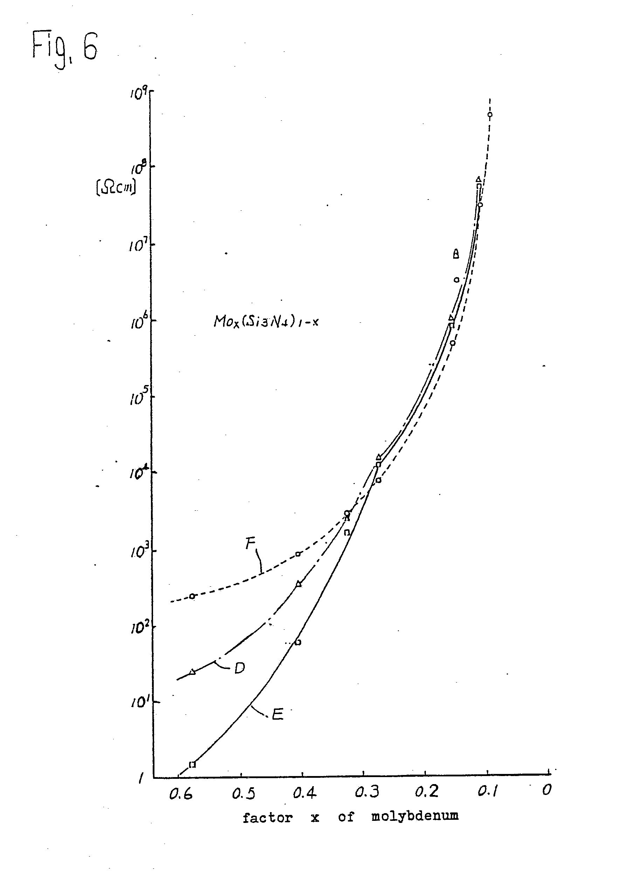

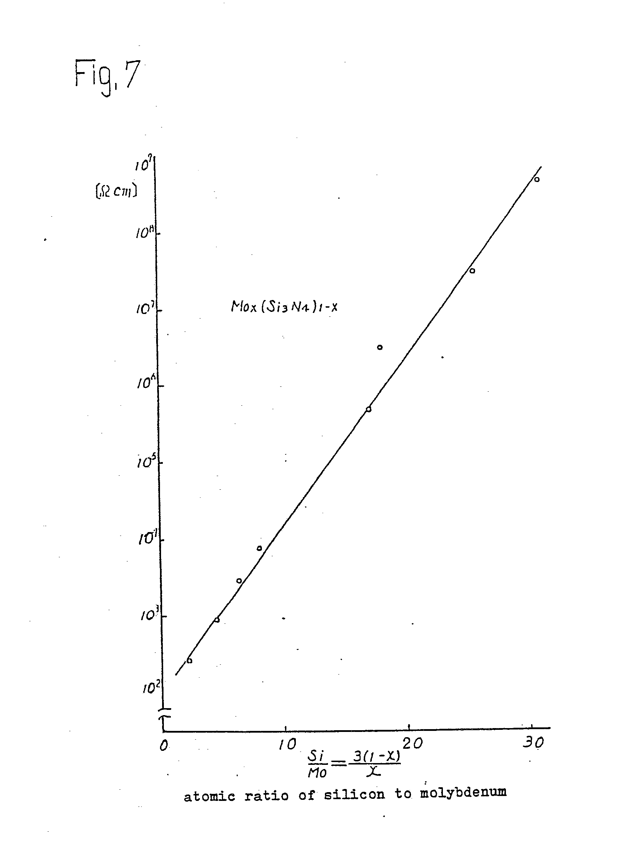

Results similar to those given above were obtained with resistor materials employing molybdenum (Mo), rather than tungsten, in accordance with another embodiment of the present invention, as illustrated in the graphs of figs. 6 and 7. The structure of the resistor materials is in this case denoted by $Mo_x(Si_3N_4)_{1-x}$. Fig. 6 illustrates relationship between resistivity ($\Omega$ cm) of the resistors materials and the composition factor x. In Fig. 6, curve D (chain line) shows values of the resistivity immediately after formation of the resistor materials, curve E (solid line) shows values of resistivity after the resistor materials had been subjected to heat treatment at 800°C and curve F (broken line) shows values of resistivity after the resistor materials had been subjected to heat treatment at 1000°C. The results (values of resistivity) illustrated by curve F in Fig. 6 are re-plotted in fig. 7, against atomic ratio of silicon to molybdenum Si/Mo=3(1−x)/x. The results are similar to those shown in Fig. 5 in a case in which tungsten (W) is utilized, but the range of resistivity values obtained is $10^2$ to $10^9$ $\Omega$ cm (1 to $10^7$ $\Omega$ m), greater by one order of magnitude.

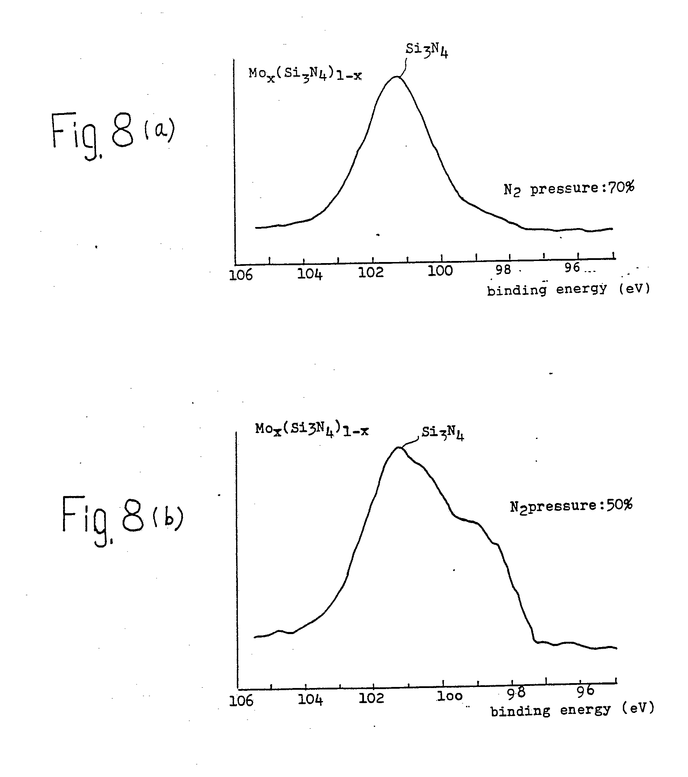

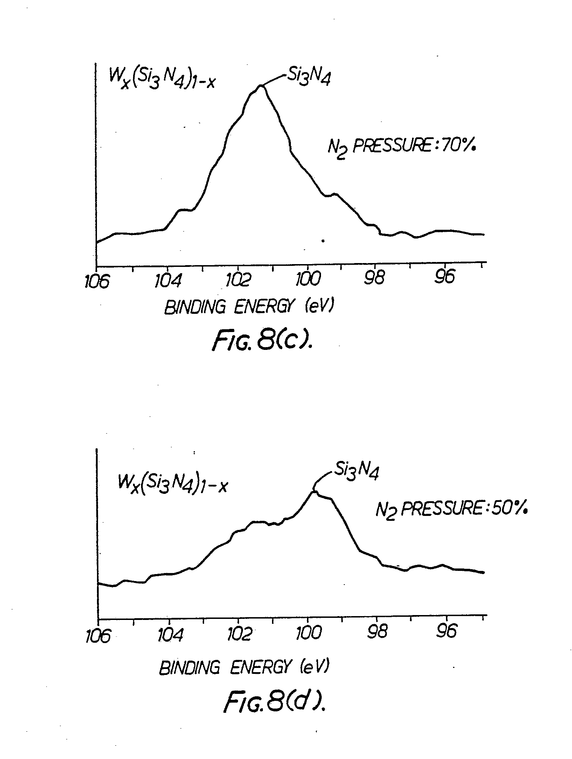

A remarkable feature of the structure of resistor materials in accordance with embodiments of the present invention is the formation of silicon nitride ($Si_3N_4$) (by reactive sputtering). Such formation has been proved experimentally to occur by an X-ray photo-spectroscopy (XPS) method with regard to $W_x(Si_3N_4)_{1-x}$ and $Mo_x(Si_3N_4)_{1-x}$ layers, in which silicon nitride $(Si_3N_4)$ was found to be formed during a reactive sputtering method. The sputtering atmosphere was a gas mixture of argon (Ar) and nitrogen $(N_2)$. The partial gas pressure of the nitrogen was selected from 50% to 70% of the total gas pressure which was fixed at $10^{-3}$ Torr. $(1.334 \times 10^{-1}$ Pa). The results obtained by X-ray photo-spectroscopy (XPS) are illustrated in the graphs of Figs. 8 (a) to 8(d). In these graphs numbers of counts appear on the ordinates and binding energy in eV on the abscissas. Materials and nitrogen gas pressures relevant to the graphs are indicated in the Figures. The values of binding energy at which peaks of the curves in the graphs appear indicate clearly the presence of silicon nitride $(Si_3N_4)$ in each case.

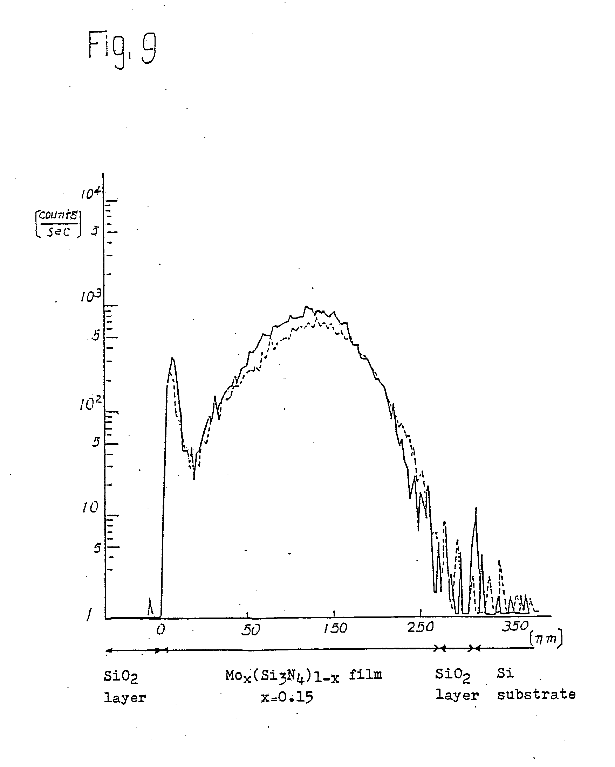

As indicated above, polysilicon resistors are easily influenced by dopants contained in adjacent doped silicon regions. Resistors embodying this invention are substantially immune from influence by the dopants usually used in IC fabrication. This was verified by experiment as follows. A probe with a film of resistive material denoted by $Mo_x(Si_3N_4)_{1-x}$, where x was taken to be 0. 15, was prepared. Phosphorus (P) was implanted with a dose of $2 \times 10^{15}$ atm/cm$^2$ $(2 \times 10^{19}$ atm/m$^2$) at an acceleration energy of 100 KeV. A covering of a silicon dioxide $(SiO_2)$ layer was provided and heating in a nitrogen atmosphere in a furnace at 1000°C for 30 minutes effected. The distribution of dopant (P) concentration in the probe before and after the heat treatment were measured using a SIMS (secondary ion mass-spectroscopy) method. The results are illustrated graphically in Fig. 9. Depth from surface of the probe appears on the abscissa in Fig. 9. The compostion of the probe at the relevant depth is indicated under the abscissa. The point on the abscissa corresponding to the depth indicated at 0 nm indicates the surface of the resistive material film. The solid line shows the distribution of P dopants before the heat treatment and the broken line shows the distribution after the heat treatment. Apparently the two curves coincide closely, indicating that the mobility of the phosphorus dopants in the resistive material is satisfactorily small. Similarly experiments were carried out to study the behavior of other dopant types, arsenic (As) and boron (B), which demonstrated that these dopants have also small mobility in resistive material according to the present invention. As a conclusion, a resistor according to the present invention is quite immune from the influence of dopants conventionally used in ICs.

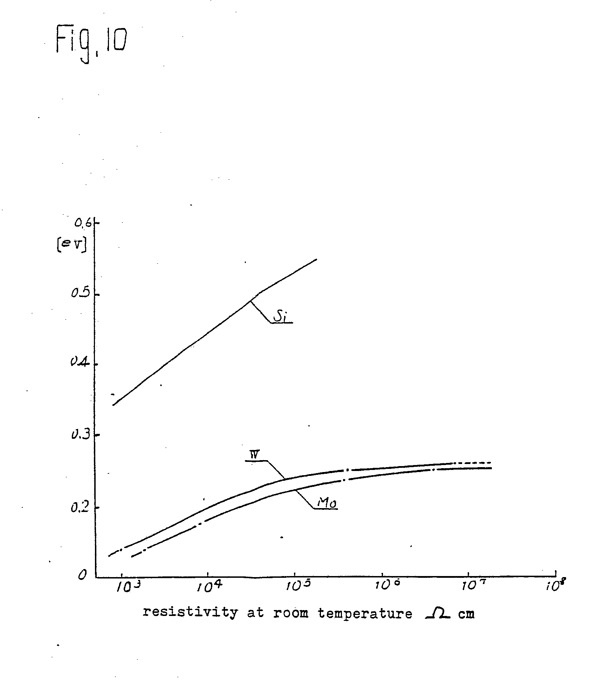

In order to examine the temperature dependency of resistor materials and resistors embodying this invention, the activation energy for the resistivity was measured by a conventional way. The results are plotted in Fig. 10, where activation energy in eV appears on the ordinate and resistivity at room temperature appears on the abscissa.

Curves labelled W and Mo respectively show the activation energies of $W_x(Si_3N_4)_{1-x}$ and $Mo_x(Si_3N_4)_{1-x}$. The curve labelled Si shows the activation energy of polysilicon, taken from the report referred to above by Lu and others. From these curves, the activation energy of the resistivity of resistor materials in accordance with embodiments of this invention is approximately 40% of that of polysilicon. This smaller temperature dependency of the resistivity of the resistor materials enhances freedom of thermal design of ICs wherein resistors of such materials are employed.

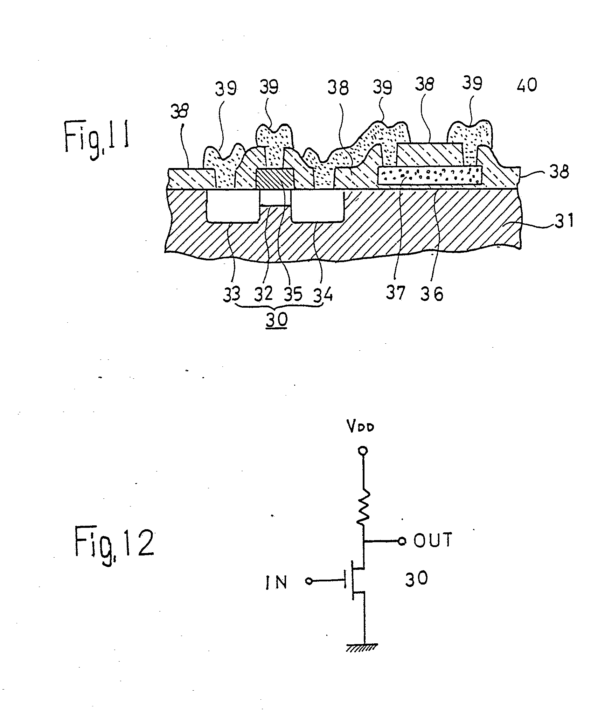

Fig. 11 is a cross-sectional view of a gallium-arsenide (GaAs) compound semiconductor device, wherein a resistor according to an embodiment of the present invention is applied, and Fig. 12 is an equivalent circuit diagram of the device of Fig. 11.

A field effect transistor 30 of Schottky-barrier type, comprising a channel region 32, an n-type source region 33, a n-type drain region 34 and a gate electrode 35, is formed in a gallium-arsenide (GaAs) substrate 31. An input-signal is applied to the gate electrode 35 through a wiring line 39 which is formed on an insulating layer 38. A thin film resistor 37, in accordance with an embodiment of the present invention, is formed as a load resistor over an insulating layer 36 covering the substrate 31 and connected to the drain region 34 and a Vdd power source. The transistor 30 is an enhancement mode transistor and has a gate electrode 2 µm long and 10 µm wide and its threshold voltage is approximately 0.15V. The transconductance of the transistor gm is approximately 130 mS/mm $(130 \times 10^2$ Ms/m) and the load resistance is 2800 Ω. The resistive layer forming the resistor was in one case formed by a reactive sputtering method wherein tungsten (W) and silicon (Si) were co-sputtered at the same time in an atmosphere of nitrogen $(N_2)$ and argon (Ar). The atomic ratio of W:Si was from 1:1 to 1:0.6. The resistivity of resistor 17 is lower than that in the case of the previously described embodiments of the present invention, being $10^{-1}$ to $10^{-3}$ Ω cm $(10^{-3}$ to $10^{-5}$ Ω m) for instance. In another case the resistor was made using a W:Si ratio = 1:2 and a nitrogen partial pressure of $0.75{\sim}0.67 \times 10^{-3}$ Torr $(1{\sim}0.894 \times 10^{-1}$ Pa). The resistivity of the resistor this made is in the range 1 to 0.1 Ω cm $(10^{-2}$ to $10^{-3}$ Ω m). The quantity of silicon nitride $(Si_3N_4)$ contained is smaller than that of the preceding embodiments and the content of tungsten silicide $(W_5Si_3)$ is dominant over that of tungsten (W).

Especially, thin film resistors in accordance with the present invention and containing tungsten (W) are suitable for use in the fabrication of Ga-As compound semiconductor integrated circuits because tungsten does not affect the device characteristics. In other words, tungsten does not react with Ga-As compounds even after annealing at 500°C for two hours, whereas tantalum (Ta) easily diffuses into Ga-As at 425°C annealing.

Additionally, GA-AS FET's can have tungsten silicide gates and such thin film resistors containing tungsten can be formed by using the same sputtering apparatus including the predetermined nitrogen partial pressure. Therefore, such thin film resistors containing tungsten are feasible for the production of gallium-arsenide ICs.

The method used for forming resistors in accordance with embodiments of this invention need not be a reactive sputtering method. Other methods such as a chemical vapour deposition (CVD) method, a reactive evaporation method utilizing an electron beam, and a plasma ion reactive sputtering method are applicable. Neither is there any limitation of embodiments of this invention to use in connection with ICs. Resistors, and methods of forming them, in accordance with embodiments of this invention, can be applied to discrete resistors, such as a resistor network formed on a ceramic substrate or discrete film resistors for hybrid circuits. One particular application of a resistor in accordance with an embodiment of this invention would be a thermal printer head in which the resistor or a resistor array formed on a glazed ceramic substrate is used as means for necessary heat generation.

The present invention for example provides a thin film resistor, for example for use in microelectronic devices, having a resistive layer comprising silicon nitride ($Si_3N_4$) and refractory metals of tungsten and/or molybdenum. The resistor has a structure in which the film comprises silicon nitride layers and grains of metal and/or metal silicide, wherein the resistivity is mainly determined by the silicon nitride contained. Therefore, the total resistance of the resistor can be controlled by the amount of the silicon nitride providing a wide range of resistivity of $10^{-3}$ to $10^{-9}\,\Omega$ cm ($10^{-5}$ to $10^{-7}\,\Omega$ m). Other characteristics such as immunity to dopant contained in an adjacent doped layer, heat resistivity and a low activation energy of the resistivity have been verified by associated experiments.

**Claims**

1. A thin film resistor, comprising a thin film of resistor material, which resistor material is substantially a mixture of silicon nitride and grains of tungsten and/or tungsten silicide or molybdenum and/or molybdenum silicide dispersed in the silicon nitride, formed on an insulative substrate.

2. A resistor as claimed in claim 1, wherein the thin film of resistor material is a sputtered thin film having a resistivity in the range $10^{-3}$ to $10^{-9}\,\Omega$ cm ($10^{-5}$ to $10^{-7}\,\Omega$ m).

3. A resistor as claimed in claim 1 or 2, wherein the resistor material of the thin film is substantially a mixture of silicon nitride and grains of tungsten and/or tungsten silicide, wherein the atomic ratio of silicon to tungsten is $Si/W = 3(1-x)/x$ where x is approximately in the range 0.1 to 0.6, the resistor material having a resistivity in the range of 10 to $10^8\,\Omega$ cm ($10^{-1}$ to $10^{-6}\,\Omega$ m).

4. A resistor as claimed in claim 1 or 2, wherein the resistor material of the thin film is substantially a mixture of silicon nitride and grains of molybdenum and/or molybdenum silicide, wherein the atomic ratio of silicon to molybdenum is $Si/Mo = 3(1-x)/x$ where x is approximately in the range 0.1 to 0.6, the resistor material having a resistivity in the range 1 to $10^{-9}\,\Omega$ cm ($10^{-2}$ to $10^{-7}\,\Omega$ m).

5. A resistor as claimed in claim 1 or 2, wherein the resistor material of the thin film is substantially composed of silicon nitride and tungsten silicide, having a resistivity in the range 1 to $10^{-3}\,\Omega$ cm ($10^{-2}$ to $10^{-5}\,\Omega$ m).

6. A resistor as claimed in claim 1 or 2, wherein the resistor material of the thin film is substantially a mixture of silicon nitride and tungsten or molybdenum metal and/or silicide of such metal having a structure as provided by reactive sputtering in an atmosphere containing nitrogen with a partial pressure in the range from $1 \times 10^{-4}$ to $5 \times 10^{-2}$ Torr ($1.334 \times 10^{-2}$ to 6.67 Pascal) in which silicon and metal are co-sputtered by ion-bombardment of target means containing silicon and such metal.

7. A resistor as claimed in any preceding claim, wherein the insulative substrate is a semiconductor substrate having an insulating layer thereon, the resistor material of the thin film being formed on the insulating layer.

8. A resistor as claimed in claim 7, wherein the semiconductor substrate is partially uncovered by the insulating layer and the resistor material of the thin film is formed also on the exposed surface of the semiconductor substrate.

9. A resistor as claim in any one of claims 1 to 6, wherein the insulative substrate is of ceramic material.

10. A resistor as claimed in any one of claims 1 to 6, wherein the insulative substrate is a compound semiconductor substrate having an insulating layer thereon.

11. A method of forming a thin film resistor comprised of a thin film of resistor material, which resistor material is substantially a mixture of silicon nitride and grains of tungsten and/or tungsten silicide or molybdenum and/or molybdenum silicide dispersed in the silicon nitride, on an insulative substrate, the method comprising:

forming the thin film of resistor material on the insulative substrate by the reactive sputtering process, in a nitrogen-containing atmosphere, with a partial pressure of nitrogen of at least $1 \times 10^{-4}$ Torr ($1.334 \times 10^{-2}$ Pascal), in which silicon and tungsten or molybdenum are co-sputtered by ion bombardment of target means containing silicon and tungsten or molybdenum.

12. A method as claimed in claim 11, wherein the partial pressure of nitrogen in the said atmosphere is in the range $1 \times 10^{-4}$ to $5 \times 10^{-2}$ Torr ($1.334 \times 10^{-2}$ to 6.67 Pascal).

13. A method as claimed in claim 11 or 12, wherein the said atmosphere is a mixture of nitrogen and a rare gas.

14. A method as claimed in claim 11, 12, 13, wherein the target means is a member composed of a hot-pressed mixture of powders of silicon and either tungsten or molybdenum metal having a selected mixing ratio.

15. A method as claimed in claim 11, 12 or 13, wherein said target means comprises a target of silicon and a target of either tungsten or molybdenum metal, providing a selected sputtering area ratio.

16. A method as claimed in any one of claims 11 to 16, wherein the substrate is heated in advance to approximately 500°C.

## Patentansprüche

1. Dünnfilmwiderstand, mit einem Dünnfilm aus Widerstandsmaterial, welches Widerstandsmaterial im wesentlichen eine Mischung aus Siliciumnitrid und Körnern von Wolfram und/oder Wolframsilicid oder Molybdän und/oder Molybdänsilicid ist, welches in dem Siliciumnitrid dispergiert ist, gebildet auf einem isolierenden Substrat.

2. Widerstand nach Anspruch 1, bei dem der Dünnfilm aus Widerstandsmaterial ein zerstäubter Dünnfilm ist, der einen Widerstand im Bereich von $10^{-3}$ bis $10^{-9}$ Ω cm ($10^{-5}$ bis $10^{-7}$ Ω m) hat.

3. Widerstand nach Anspruch 1 oder 2, bei dem das Widerstandsmaterial des Dünnfilms im wesentlichen eine Mischung aus Siliciumnitrid und Körnern von Wolfram und/oder Wolframsilicid ist, bei dem das Atomverhältnis von Silicium zu Wolfram Si/W = 3(1-x)/x ist, wobei x etwa im Bereich von 0,1 bis 0,6 liegt, und das Widerstandsmaterial einen Widerstand im Bereich von 10 bis $10^{-8}$ Ω cm ($10^{-1}$ bis $10^{-6}$ Ω m) hat.

4. Widerstand nach Anspruch 1 oder 2, bei dem das Widerstandsmaterial des Dünnfilms im wesentlichen eine Mischung aus Siliciumnitrid und Körnern aus Molybdän und/oder Molybdänsilicid ist, bei dem das Atomverhältnis von Silicium zu Molybdän Si/Mo = 3(1-x)/x ist, wobei x etwa im Bereich von 0,1 bis 0,6 liegt, und das Widerstandsmaterial einen Widerstand im Beriech von 1 bis $10^{-9}$ Ω cm ($10^{-2}$ bis $10^{-7}$ Ω m hat.

5. Widerstand nach Anspruch 1 oder 2, bei dem das Widerstandsmaterial des Dünnfilms im wesentlichen zusammengesetzt ist aus Siliciumnitrid und Wolframsilicid, mit einem Widerstand im Bereich von 1 bis $10^{-3}$ Ω m ($10^{-2}$ bis $10^{-5}$ Ω m).

6. Widerstand nach Anspruch 1 oder 2, bei dem das Widerstandsmaterial des Dünnfilms im wesentlichen eine Mischung aus Siliciumnitrid und wolfram- oder Molybdänmetall und/oder Silicid eines solchen Metalles ist, welches eine Struktur hat, wie sie durch reaktives Zerstäuben in einer Atmosphäre erreicht wird, welche Stickstoff mit einem Partialdruck im Bereich von $1 \times 10^{-4}$ bis $5 \times 10^{-2}$ Torr ($1,334 \times 10^{-2}$ bis 6,67 Pascal) hat, in welcher Silicium und Metall durch Ionenbombardement der Targeteinrichtung, welche Silicium und ein solches Metall enthält, co-zerstäubt werden.

7. Widerstand nach einem der vorhergehenden Ansprüche, bei dem das isolierende Substrat ein Halbleitersubstrat ist, welches eine isolierende Schicht darauf enthält, wobei das Widerstandsmaterial des Dünnfilms auf der isolierenden Schicht geformt ist.

8. Widerstand nach Anspruch 7, bei dem das Halbleitersubstrat teilweise von der isolierenden Schicht unbedeckt ist und das Widerstandsmaterial des Dünnfilms auch auf der exponierten Oberfläche des Halbleitersubstrats gebildet ist.

9. Widerstand nach einem der Ansprüche 1 bis 6, bei dem das isolierende Substrat aus keramischem Material besteht.

10. Widerstand nach einem der Ansprüche 1 bis 6, bei dem das isolierende Substrat ein Verbindungshalbleitersubstrat ist, auf welchem eine isolierende Schicht ist.

11. Verfahren zur Bildung eines Dünnfilmresistors, mit einem Dünnfilm aus Widerstandsmaterial, welches Widerstandsmaterial im wesentlichen eine Mischung aus Siliciumnitrid und Körnern aus Wolfram und/oder Wolframsilicid oder Molybdän und/oder Molybdänsilicid ist, welche in dem Siliciumnitrid dispergiert sind, auf einem isolierenden Substrat, welches Verfahren umfaßt: Bildung des Dünnfilms aus Widerstandsmaterial auf dem isolierenden Substrat durch einen reaktiven zerstäubungs-Prozess, in einer stickstoffhaltigen Atmosphäre, mit einem Partialdruck von Stickstoff von wenigstens $1 \times 10^{-4}$ Torr ($1,334 \times 10^{-2}$ Pascal), bei welchem Silicium und Wolfram oder Molybdän durch Ionenbombardement der Targeteinrichtung, die Silicium und Wolfram oder Molybdän enthält, co-zerstäubt werden.

12. Verfahren nach Anspruch 11, bei dem der Partialdruck des Stickstoffs in der genannten Atmosphäre im Bereich von $1 \times 10^{-4}$ bis $5 \times 10^{-2}$ Torr ($1,334 \times 10^{-2}$ bis 6,67 Pascal) liegt.

13. Verfahren nach Anspruch 11 oder 12, bei dem die genannte Atmosphäre eine Mischung aus Stickstoff und einem Edelgas ist.

14. Verfahren nach Anspruch 11, 12, oder 13, bei dem die Targeteinrichtung ein Teil ist, welches aus einer heiß-gepreßten Mischung aus Pulver von Silicium und entweder Wolfram- oder Molybdänmetall, welches ein ausgewähltes Mischungsverhältnis hat, ist.

15. Verfahren nach Anspruch 11, 12 oder 13, bei dem die Targeteinrichtung ein Target aus Silicium oder ein Target aus entweder Wolfram- oder Molybdänmetall ist, welches ein ausgewähltes Zerstäubungsbereichsverhältnis vorsieht.

16. Verfahren nach einem der Ansprüche 11 bis 16, bei dem das Substrat im voraus auf etwa 500°C erhitzt wird.

## Revendications

1. Résistance en couche mince comprenant une couche mince de matériau résistant, lequel matériau résistant est sensiblement un mélange de nitrure de silicium et de grains de tungstène et/ou de siliciure de tungstène ou de molybdène et/ou de siliciure de molybdène dispersé dans le nitrure de silicium, formée sur un substrat isolant.

2. Résistance selon la revendication 1, dans laquelle le couche mince de matériau résistant est une couche mince obtenue par pulvérisation ayant une résistivité dans la gamme de $10^{-3}$ à $10^{-9}$ Ω cm ($10^{-5}$ a $10^{-7}$ Ω m).

3. Résistance selon l'une des revendications 1 ou 2, dans laquelle le matériau résistant de la couche mince est sensiblement un mélange de nitrure de silicium et de grains de tungstène et/ou siliciure de tungstène, dans lequel le rapport atomique du silicium au tungstène est Si/W = 3(1-x)/x où x est environ dans la gamme de 0,1 à 0,6, le matériau résistant ayant une résistivité dans la gamme de 10 à $10^{-8}$ Ω cm ($10^{-1}$ à $10^{-6}$ Ω m).

4. Résistance selon l'une des revendications 1 ou 2, dans laquelle le matériau résistant de la couche mince est sensiblement un mélange de nitrure de silicium et de grains de molybdène et/ou de siliciure de molybdène, dans lequel le rapport atomique du silicium au mobybdène est Si/Mo = 3(1-x)/x où x est environ dans la gamme de 0,1 à 0,6, le matériau résistant ayant une résistivité dans la gamme de 1 à $10^{-9}$ Ω cm ($10^{-2}$ à $10^{-7}$ Ω m).

5. Résistance selon l'une quelconque des revendications 1 ou 2, dans laquelle le matériau résistant de la couche mince est sensiblement constitué de nitrure de silicium et de siliciure de tungstène, ayant une résistivité dans la gamme de 1 à $10^{-3}$ Ω cm ($10^{-2}$ à $10^{-5}$ Ω m).

6. Résistance selon l'une des revendications 1 ou 2, dans laquelle le matériau résistant de la couche mince est sensiblement un mélange de nitrure de silicium et de tungstène ou de molybdène métallique et/ou de siliciure d'un tel métal ayant une structure telle que fournie par pulvérisation réactive dans une atmosphère contenant de l'azote avec une pression partielle dans la gamme de $1 \times 10^{-4}$ à $5 \times 10^{-2}$ Torr ($1,334 \times 10^{-2}$ à 6,67 Pascal) dans laquelle le silicium et le métal sont simultanément pulvérisés par bombardement ionique d'un moyen de cible contenant du silicium et ce métal.

7. Résistance selon quelconque des revendications précédentes dans laquelle le substrat isolant est un substrat semiconducteur revêtu d'une couche isolante, le matériau résistant de la couche mince étant formé sur la couche isolante.

8. Résistance selon la revendication 7, dans laquelle le substrat semiconducteur est partiellement couvert de la couche isolante et le matériau résistant de la couche mince est également formé sur la surface exposé du substrat semiconducteur.

9. Résistance selon l'une quelconque des revendications 1 à 6, dans laquelle le substrat isolant est un matériau de céramique.

10. Résistance selon l'une quelconque des revendications 1 à 6, dans laquelle le substrat isolant est en subtrat semiconducteur composé portant une couche isolante.

11. Procédé de fabrication d'une résistance en couche mince comprenant une couche mince de matériau résistant, lequel matériau résistant est sensiblement un mélange de nitrure de silicium et de grains de tungstène et/ou de siliciure de tungstène ou de molybdène et/ou de siliciure de molybène dispersé dans le nitrure de silicium, sur un substrat isolant, ce procédé comprenant:

la formation de la couche mince de matériau résistant sur le substrat isolant par un procédé de pulvérisation réactive dans une atmosphère contenant de l'azote, sous une pression partielle d'azote d'au moins $1 \times 10^{-4}$ Torr ($1,334 \times 10^{-2}$ Pascal), dans lequel le silicium et le tungstène ou le molybdène sont simultanément pulvérisés par bombardem ent ionique d'un moyen de cible contenant du silicium et du tungstène ou du molybdène.

12. Procédé selon la revendication 11, dans lequel la pression partielle d'azote dans ladite atmosphère se trouve dans la gamme de $1 \times 10^{-4}$ à $5 \times 10^{-2}$ Torr ($1,334 \times 10^{-2}$ à 6,67 Pascal).

13. Procédé selon la revendication 11 ou 12, dans lequel ladite atmosphère est un mélange d'azote et d'un gaz rare.

14. Procédé selon l'une des revendications 11, 12, 13, dans lequel le moyen de cible est un élément constitué d'un mélange comprimé à chaud de poudres de silicium et de tungstène ou de molybdène métallique ayant un taux de mélange choisi.

15. Procédé selon l'une des revendications 11, 12 ou 13 dans lequel le moyen de cible comprend une cible de silicium et une cible de tungstène ou de molybdène métallique, fournissant un taux de surface de pulvérisation choisi.

16. Procédé selon l'une quelconque des revendications 11 à 15, dans lequel le substrat est chauffé à l'avance à environ 500°C.

Fig. 1

Fig. 2

Fig. 3

Fig. 4

$W_x (Si_3 N_4)_{1-x}$

factor x of tungsten

# Fig. 5

$[\Omega\,cm]$

$$W_x(Si_3N_4)_{1-x}$$

$$\frac{Si}{W}=\frac{3(1-x)}{x}$$

atomic ratio of silicon to tungsten

Fig. 6

factor x of molybdenum

Fig. 7

$$\frac{Si}{Mo} = \frac{3(1-X)}{X}$$

atomic ratio of silicon to molybdenum

Fig. 8 (a)

$Mo_x(Si_3N_4)_{1-x}$   Si₃N₄ (Si₃N₄)

N₂ pressure:70%

106    104    102    100    98    96 ...
binding energy (eV)

Fig. 8 (b)

$Mo_x(Si3N_4)_{1-x}$   Si₃N₄

N₂pressure:50%

106    104    102    1oo    98    96
binding energy (eV)

$W_x(Si_3N_4)_{1-x}$  —$Si_3N_4$

$N_2$ PRESSURE: 70%

106    104    102    100    98    96

BINDING ENERGY (eV)

*Fig. 8(c).*

$W_x(Si_3N_4)_{1-x}$  $Si_3N_4$

$N_2$ PRESSURE: 50%

106    104    102    100    98    96

BINDING ENERGY (eV)

*Fig. 8(d).*

Fig. 9

SiO₂        Moₓ(Si₃N₄)₁₋ₓ film        SiO₂      Si
layer            x=0.15             layer    substrate

Fig. 10

resistivity at room temperature Ω cm

Fig.11

Fig.12